# FASCICULE DE BREVET EUROPEEN

(11) **EP 3 622 557 B1**
(45) Date de publication et mention de la délivrance du brevet: **09.06.2021**
(21) Numéro de dépôt: 18749014.9
(22) Date de dépôt: 27.06.2018
(51) Int. Cl.: H01L 27/15, H01L 33/06, H01L 33/32, H04N 9/31, G02B 27/18, H04N 5/74

(54) **PROJECTEUR COULEUR À DEUX ÉCRANS ÉMISSIFS**
FARBPROJEKTOR MIT ZWEI EMISSIVEN ANZEIGEN
COLOUR PROJECTOR WITH TWO EMISSIVE DISPLAYS

(30) Priorité: 29.06.2017 FR 1756049
(43) Date de publication de la demande: 18.03.2020
(73) Titulaire: Commissariat à l'énergie atomique et aux énergies alternatives, 75015 Paris (FR); Thales, 92400 Courbevoie (FR)
(72) Inventeur: TEMPLIER, François, 38054 Grenoble Cedex 9 (FR); LUC, François-Henri, 92098 Paris La Defense (FR)
(74) Mandataire: Brevalex
(86) Numéro de dépôt international: PCT/FR2018/051565
(87) Numéro de publication internationale: WO 2019/002757

(56) Documents cités:
- WO-A1-2015/059296
- WO-A2-2007/053624
- GB-A- 2 414 127
- JP-A- 2000 180 823
- US-A1- 2004 021 831

## Description

### DOMAINE TECHNIQUE

Une image en couleurs peut être décomposée en plusieurs sous images, chacune d'une seule couleur, nommées composantes chromatiques.

Une image en couleurs est décomposée de préférence en trois sous images.

L'invention concerne le domaine des systèmes de projection d'images en couleurs, en particulier les systèmes de projection vidéo en couleurs.

Ces systèmes de projection réalisent la projection d'une image en couleurs, par projection séparée de chacune des composantes chromatiques de cette image. Les projections sont dites séparées, car elles sont séparées dans le temps ou dans l'espace.

### ÉTAT DE LA TECHNIQUE ANTÉRIEURE

On connaît dans l'art antérieur différents types de projecteurs, notamment des projecteurs configurés pour mettre en œuvre une projection en couleurs de type séquentiel.

Il s'agit de projecteurs configurés pour projeter tour à tour les différentes composantes chromatiques (monochromatiques) d'une image en couleurs (polychromatique).

Ces différentes composantes chromatiques correspondent de préférence à chacune des trois couleurs primaires en synthèse additive : le rouge, le vert et le bleu.

Dans la suite, un tel projecteur est simplement nommé « projecteur de type séquentiel ».

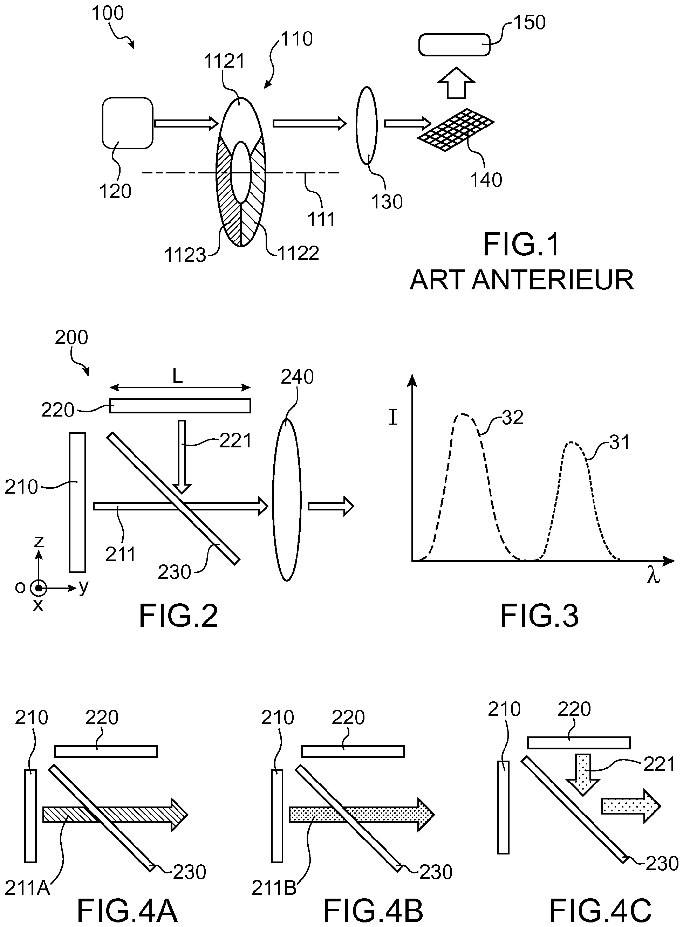

La figure 1 illustre de façon schématique un mode de réalisation connu d'un projecteur 100 de type séquentiel.

Le fonctionnement du projecteur 100 est basé sur l'utilisation d'une roue de coloration 110 à filtres. Il s'agit d'un disque rotatif, dont la surface est occupée par trois filtres spectraux en transmission 1121, 1122, 1123, transmettant respectivement le bleu, le rouge et le vert.

En fonctionnement, une source 120 de lumière blanche émet un signal continu et d'amplitude constante.

La roue de coloration 110 est disposée sur le chemin optique du faisceau lumineux émis par la source 120, et tourne sur elle-même pour prendre successivement trois positions.

Dans une première position, le faisceau lumineux émis par la source 120 traverse la roue de coloration 110 au niveau d'un premier filtre spectral 1121 transmettant le bleu uniquement. Dans une deuxième position, ce faisceau traverse la roue de coloration 110 au niveau d'un deuxième filtre spectral 1122 transmettant le rouge uniquement. Dans une troisième position, ce faisceau traverse la roue de coloration 110 au niveau d'un troisième filtre spectral 1123 transmettant le vert uniquement.

Le faisceau lumineux en sortie de l'un de ces filtres spectraux traverse une lentille relais 130, et arrive sur un micro-écran réflectif 140 tel qu'une matrice de micro-miroirs dite DMD (pour l'anglais « *Digital Micromirror Device* »)*.*

La lentille relais permet de collimater le faisceau lumineux émis par la source 120 de lumière blanche, et peut donc également se situer en amont de la roue de coloration 110.

Le micro-écran réflectif 140 reçoit un signal sensiblement uniforme dans l'espace. Chaque micro-miroir du micro-écran réflectif 140 reçoit une portion de ce signal, et peut pivoter entre une position dans laquelle ladite portion de signal est renvoyée vers un système optique de projection 150, et une position dans laquelle ladite portion de signal est renvoyée vers une autre direction. A partir de ces deux positions, on peut former différents niveaux de gris, en faisant varier une proportion de durée durant laquelle le signal est renvoyé vers le système optique de projection 150.

Ainsi, le micro-écran réflectif 140 transforme un faisceau lumineux représentatif d'une image uniforme, en un faisceau lumineux représentatif d'une image pixellisée, et en niveaux de gris.

Le micro-écran réflectif 140 forme successivement différentes images pixellisées, en niveaux de gris.

La fréquence de succession des positions de la roue de coloration 110, et la fréquence de succession des images formées par le micro-écran réflectif 140, sont synchronisées ensemble.

Ainsi, le micro-écran réflectif renvoie tour à tour, vers le système optique de projection 150, une image bleue, verte puis rouge, et ainsi de suite.

En renvoyant tour à tour, vers le système optique de projection 150, les composantes bleue, verte et rouge d'une même image en couleurs, le projecteur 100 réalise une projection d'images en couleurs, de type séquentiel.

Un inconvénient de ce mode de réalisation est cependant son encombrement.

En outre, les filtres spectraux composant la roue de coloration 110 présentent chacun un coefficient de transmission d'environ 30%, ce qui limite grandement le rendement énergétique du projecteur 100.

Un objectif de la présente invention est de proposer un projecteur d'images en couleurs, qui présente un encombrement réduit.

Un autre but de la présente invention est de proposer un projecteur d'images en couleurs, qui offre un bon rendement énergétique.

Les documents JP 2000 180823 A, WO 2007/053624 A2 et WO 2015/059296 A1 décrivent des systèmes de projection d'images.

### EXPOSÉ DE L'INVENTION

Cet objectif est atteint avec un système de projection d'images, configuré pour mettre en œuvre une projection en couleurs, et comprenant :
- un premier dispositif matriciel d'affichage émissif, configuré pour l'émission d'une première et d'une deuxième composantes chromatiques d'une image en couleurs, et comprenant une première matrice de pixels dans laquelle chaque pixel est adapté à émettre aux longueurs d'onde associées à ladite première composante chromatique et aux longueurs d'onde associées à ladite deuxième composante chromatique ; et
- un second dispositif matriciel d'affichage émissif, configuré pour l'émission d'une troisième composante chromatique de l'image en couleurs.

L'invention propose donc de s'affranchir entièrement du concept des filtrages en longueurs d'onde, et d'utiliser plutôt des dispositifs matriciels d'affichage émissif fournissant directement des signaux aux longueurs d'onde souhaitées.

On s'affranchit donc des pertes liées aux filtrages, ce qui permet d'obtenir un projecteur d'images en couleurs, qui offre un bon rendement énergétique.

L'invention propose également de remplacer une source lumineuse, et un élément matriciel de formation d'une image, distincts l'un de l'autre, par des dispositifs matriciels d'affichage émissif réalisant à la fois les fonctions d'émission lumineuse et de formation d'image.

On peut ainsi obtenir un projecteur d'images en couleurs, compact, présentant un encombrement réduit.

Cet encombrement est d'autant plus réduit, qu'un unique dispositif matriciel d'affichage émissif permet, selon l'invention, de fournir deux des trois composantes chromatiques d'une image en couleurs.

L'utilisation de seulement deux dispositifs matriciels d'affichage émissif, pour l'émission des trois composantes chromatiques d'une image en couleurs, permet également de simplifier des moyens de déviation de faisceau, mis en œuvre pour faire en sorte que les trois composantes chromatiques de l'image émergent du système de projection d'images selon un même chemin optique.

L'utilisation de seulement deux dispositifs matriciels d'affichage émissif, pour l'émission des trois composantes chromatiques d'une image en couleurs, permet également de réduire un coût de fabrication du système de projection d'images.

Enfin, la solution proposée ici se distingue d'une solution évidente, qui aurait consisté à utiliser un dispositif d'affichage émissif trichrome, constitué d'une matrice de macro-pixels, chaque macro-pixel étant constitué d'au moins un pixel bleu, un pixel vert et un pixel rouge.

Selon l'invention, la projection peut être entièrement séquentielle (le système de projection d'images émet tour à tour chacune des trois composantes chromatiques d'une image), ou partiellement séquentielle (le premier dispositif matriciel d'affichage émissif émet tour à tour la première et la deuxième composantes chromatiques d'une image, pendant que le second dispositif matriciel d'affichage émissif émet la troisième composante chromatique de la même image). La projection, au moins partiellement séquentielle, donne accès à de plus hautes résolutions d'affichage. En outre, tous les pixels de chacun des deux dispositifs matriciels d'affichage émissif peuvent présenter le même spectre d'émission, ce qui simplifie leur fabrication.

Le premier dispositif d'affichage émissif n'est pas non plus constitué de macro-pixels comportant chacun deux types de pixels, un premier type pour l'émission de la première composante chromatique, et un second type pour l'émission de la deuxième composante chromatique. Il comprend au contraire une matrice de pixels dans laquelle chaque pixel participe à la formation de la première, et de la deuxième composantes chromatiques de l'image en couleurs. Ainsi, tous les pixels de ladite matrice peuvent présenter les mêmes caractéristiques spectrales en émission, ce qui donne accès à de plus hautes résolutions d'affichage, et simplifie la fabrication du premier dispositif d'affichage émissif.

En fonctionnement, les premier et second dispositifs matriciels d'affichage émissif projettent des images correspondant aux différentes composantes chromatiques d'une image en couleurs, chacune de ces images étant une image « en niveaux de gris », chaque niveau de gris correspondant à une valeur prédéterminée de luminance (le cas échéant moyennée temporellement par l'œil).

Le système selon l'invention présente avantageusement les caractéristiques suivantes :
- ladite première matrice de pixels est constituée d'une première matrice de diodes électroluminescentes, dans laquelle chaque diode électroluminescente présente un spectre d'émission qui dépend de l'amplitude de sa tension d'alimentation ; et
- le premier dispositif matriciel d'affichage émissif est connecté à des premiers moyens de pilotage, configurés pour fournir auxdites diodes électroluminescentes des tensions d'alimentation respectives présentant alternativement une première amplitude, associée à l'émission de la première composante chromatique, et une seconde amplitude, associée à l'émission de la deuxième composante chromatique.

Les premiers moyens de pilotage peuvent comprendre des unités de modulation de largeur d'impulsion, chaque diode électroluminescente de ladite première matrice étant associée à une unité de modulation de largeur d'impulsion respective.

De préférence, les diodes électroluminescentes de ladite première matrice sont des diodes à multi-puits quantiques, comprenant chacune deux types de puits quantiques, qui diffèrent par un spectre d'émission respectif associé.

En variante, les diodes électroluminescentes de ladite première matrice peuvent être des diodes à multi-puits quantiques, comprenant chacune des puits quantiques d'un seul type, tous associés à un même spectre d'émission.

De préférence, les diodes électroluminescentes de ladite première matrice sont des diodes à base de nitrure de gallium-indium (InGaN).

De préférence, le second dispositif matriciel d'affichage émissif comprend une seconde matrice de diodes électroluminescentes, à base de phosphure d'aluminium-gallium-indium (InGaAIP).

De manière avantageuse :
- le premier dispositif matriciel d'affichage émissif est configuré pour l'émission d'une composante verte et d'une composante bleue d'une image en couleurs ; et
- le second dispositif matriciel d'affichage émissif est configuré pour l'émission d'une composante rouge de ladite image en couleurs.

Le système de projection d'images selon l'invention peut présenter en outre des moyens de déviation de faisceau, agencés pour superposer les chemins optiques suivis par les signaux lumineux émis respectivement par le premier et par le second dispositifs matriciels d'affichage émissif.

Les moyens de déviation de faisceau peuvent consister en un miroir dichroïque.

Avantageusement, le premier dispositif matriciel d'affichage émissif comprend ladite première matrice de pixels, le second dispositif matriciel d'affichage émissif comprend une seconde matrice de pixels, et chacune des première et seconde matrices de pixels est une matrice carrée ou rectangulaire de côté(s) compris entre 5 mm et 20 mm.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1 illustre de manière schématique, un projecteur d'images en couleurs de type séquentiel, selon l'art antérieur ;
- la figure 2 illustre de manière schématique, un premier mode de réalisation d'un système de projection d'images selon l'invention ;
- la figure 3 illustre les spectres d'émission du premier dispositif matriciel d'affichage émissif du système de la figure 2 ;
- les figures 4A à 4C illustrent de manière schématique le fonctionnement du système de la figure 2 ;
- la figure 5 illustre de manière schématique le pilotage du premier dispositif matriciel d'affichage émissif du système de la figure 2 ;
- la figure 6A illustre les spectres d'émission du premier dispositif matriciel d'affichage émissif d'un deuxième mode de réalisation d'un système de projection d'images selon l'invention ; et
- la figure 6B illustre ledit deuxième mode de réalisation d'un système selon l'invention.

### EXPOSÉ DÉTAILLÉ DE MODES DE RÉALISATION PARTICULIERS

La figure 2 illustre de façon schématique un premier mode de réalisation d'un système 200 de projection d'images, selon l'invention.

Le système 200 comprend en particulier :
- un premier dispositif matriciel d'affichage émissif 210, comprenant une première matrice de pixels ; et
- un second dispositif matriciel d'affichage émissif 220, comprenant une seconde matrice de pixels.

Les pixels de la première matrice de pixels sont répartis selon une matrice carrée (ou rectangulaire), de côté(s) L (respectivement L1, L2 pour une matrice rectangulaire) compris ici entre 5 mm et 20 mm.

Ces pixels sont répartis ici selon un même pas P inférieur à 10 µm, par exemple égal à 5 µm.

Le premier dispositif matriciel d'affichage émissif 210 et le second dispositif matriciel d'affichage émissif 220 forment chacun un micro-écran.

La première et la deuxième matrices de pixels présentent avantageusement les mêmes dimensions, et le même pas de pixel.

Chacun des premier et second dispositifs matriciels d'affichage émissif est adapté à fournir un éclairement de très forte intensité lumineuse, par exemple plus de 10³ Cd/m², et même jusqu'à 10⁷ Cd/m².

Chaque pixel de la première, respectivement seconde matrice de pixels, est constitué ici d'une diode électroluminescente (LED). Chaque matrice de pixels forme donc une matrice de LED.

Ces diodes électroluminescentes peuvent être nommées micro-LED, du fait de leurs dimensions de l'ordre du micromètre (pas de répartition inférieur ici à 10 µm).

La première matrice de LED, du premier dispositif matriciel d'affichage émissif 210, s'étend dans le plan (xOz) d'un repère orthonormé (Oxyz).

Elle est configurée pour émettre un signal lumineux 211 qui se propage selon l'axe (Oy), jusqu'à un miroir dichroïque 230.

La première matrice de LED est constituée de LED comportant de l'indium et du gallium, en particulier des LED à base de nitrure de gallium-indium (InGaN).

Les différentes LED de la première matrice de LED sont identiques entre elles. En d'autres termes, elles présentent toutes les mêmes dimensions et la même composition.

Selon le premier mode de réalisation de l'invention, ces LED comportent chacune des structures de deux types, leur permettant d'émettre à l'une ou l'autre longueur d'onde en fonction d'une tension d'alimentation.

En particulier, chacune de ces LED est une LED à multi-puits quantiques, comportant des multi-puits quantiques adaptés à émettre dans le bleu, c'est-à-dire à une longueur d'onde comprise entre 440 nm et 500 nm, et des multi-puits quantiques adaptés à émettre dans le vert, c'est-à-dire à une longueur d'onde comprise entre 510 nm et 570 nm.

En particulier, chacune de ces LED comporte deux structures à multi-puits quantiques superposées, qui diffèrent par un spectre d'émission respectif associé.

Plus particulièrement, chacune de ces LED comporte des empilements de couches alternativement en GaN et en InGaN, formant des puits quantiques pour des porteurs de charges. Dans une première partie de l'empilement, la concentration en Indium dans les couches en InGaN présente une première valeur, adaptée à une émission dans le bleu. Dans une deuxième partie de l'empilement, la concentration en indium dans les couches en InGaN présente une deuxième valeur, adaptée à une émission dans le vert.

La structure de ces LED ne sera pas décrite ici plus avant, l'invention ne résidant pas dans les LED en tant que telles, et la réalisation de telles LED ne posant pas de difficulté particulière.

Lorsque la LED est alimentée par une première tension d'alimentation présentant une première valeur d'amplitude, non nulle, ce sont les puits quantiques d'un premier type qui sont excités, et la LED émet dans le vert.

Lorsque la LED est alimentée par une deuxième tension d'alimentation présentant une deuxième valeur d'amplitude, non nulle, ce sont les puits quantiques d'un deuxième type qui sont excités, et la LED émet dans le bleu.

La figure 3 illustre ce phénomène. La figure 3 illustre les spectres d'émission d'une telle LED (intensité lumineuse I en fonction de la longueur d'onde λ), pour ladite première tension d'alimentation (spectre 31) et pour ladite deuxième tension d'alimentation (spectre 32).

Lorsque la LED est alimentée par la première tension d'alimentation, son spectre 31 présente un pic d'émission dans le vert.

Le cas échéant, ce spectre 31 peut présenter des pics supplémentaires, non exploités par le système 200 de projection d'images, situés en dehors du spectre visible (entre 400 nm et 800 nm) et du proche ultra-violet (environ de 300 nm à 400 nm).

En tout état de cause, on considère dans la suite que le spectre 31 est monochromatique, et correspond à une émission monochromatique dans le vert.

Lorsque la LED est alimentée par la deuxième tension d'alimentation, son spectre 32 présente un pic d'émission dans le bleu.

Le cas échéant, ce spectre 32 peut présenter des pics supplémentaires, non exploités par le système 200 de projection d'images, situés en dehors du spectre visible et du proche ultra-violet.

En tout état de cause, on considère dans la suite que le spectre 32 est monochromatique, et correspond à une émission monochromatique dans le bleu.

La première tension d'alimentation est strictement inférieure à la deuxième tension d'alimentation.

La différence entre ces deux tensions est par exemple comprise entre 0,5 et 1,5 V.

Ici, la première tension d'alimentation vaut 4 V, et la deuxième tension d'alimentation vaut 5 V.

On remarque que l'on peut considérer indifféremment le courant d'alimentation et la tension d'alimentation, ces deux paramètres étant liés, leurs valeurs respectives augmentant ensemble ou baissant ensemble.

En fonctionnement, toutes les LED de la première matrice de LED sont alimentées à chaque instant par des tensions d'alimentation respectives présentant toutes une même amplitude. Cette amplitude correspond alternativement à la première puis à la deuxième tension d'alimentation telles que décrites ci-dessus.

Ainsi, en fonction de la tension d'alimentation des LED, la première matrice de LED est adaptée à émettre :
- un signal lumineux 211A présentant le spectre d'émission 31 (voir figure 4A) ; ou
- un signal lumineux 211B présentant le spectre d'émission 32 (voir figure 4B).

Les signaux lumineux 211A et 211B ne sont pas émis simultanément, mais l'un après l'autre.

Les signaux lumineux 211A et 211B sont formés chacun par l'illumination produite par la première matrice de LED du premier dispositif matriciel d'affichage émissif 210.

Ils correspondent donc chacun à une image pixellisée « en niveaux de gris », formée sur ladite matrice de LED, où chaque pixel de l'image correspond à une LED de la matrice de LED, et où le niveau de gris de ce pixel correspond à la luminance de la LED associée.

Dans la suite, on considère que ce niveau de gris correspond également à l'intensité lumineuse du faisceau émis par la LED associée.

Le signal lumineux 211A présente un spectre en longueur d'onde avec un pic d'émission dans le vert.

Ce signal lumineux 211A correspond à la composante verte d'une image en couleurs.

Le signal lumineux 211B présente un spectre en longueur d'onde avec un pic d'émission dans le bleu.

Ce signal lumineux 211B correspond à la composante bleue d'une image en couleurs.

La seconde matrice de LED, du second dispositif matriciel d'affichage émissif 220, s'étend dans le plan (xOy) du même repère orthonormé (Oxyz).

Elle s'étend donc ici orthogonale à la première matrice de LED.

Elle est configurée pour émettre un signal lumineux 221 qui se propage selon l'axe (Oz), jusqu'au miroir dichroïque 230.

La seconde matrice de LED est constituée de LED comportant de l'indium et du gallium, en particulier des LED à base de phosphure d'aluminium-gallium-indium (InGaAIP).

Les différentes LED de la seconde matrice de LED sont identiques entre elles. En d'autres termes, elles présentent toutes les mêmes dimensions et la même composition.

La seconde matrice de LED présente un spectre d'émission avec un pic d'émission dans le rouge, c'est-à-dire centré sur une longueur d'onde comprise entre 600 nm et 750 nm.

Le cas échéant, ce spectre d'émission peut présenter des pics supplémentaires, non exploités par le système de projection d'images, situés en dehors du spectre visible et du proche ultra-violet, par exemple situés dans l'infrarouge.

En tout état de cause, on considère dans la suite que le second dispositif matriciel d'affichage émissif 220 fournit une émission monochromatique dans le rouge.

Là-encore, le signal lumineux 221 émis par le second dispositif matriciel d'affichage émissif 220 correspond à une image pixellisée « en niveaux de gris » formée sur la seconde matrice de LED, où chaque pixel de l'image correspond à une LED de la seconde matrice de LED, et où le niveau de gris de ce pixel correspond à la luminance de la LED associée, et à l'intensité lumineuse du faisceau émis par ladite LED associée.

Ce signal lumineux 221 correspond à la composante rouge d'une image en couleurs.

Le miroir dichroïque 230 s'étend ici incliné à 45° relativement aux axes (Oy) et (Oz), parallèle à l'axe (Ox).

Il est adapté ici à transmettre des longueurs d'onde inférieures à 580 nm, et réfléchir des longueurs d'onde supérieures à 580 nm.

Ainsi, le signal lumineux 211 émis par le premier dispositif matriciel d'affichage émissif traverse le miroir dichroïque 230, alors que le signal lumineux 221 émis par le second dispositif matriciel d'affichage émissif se réfléchit sur le miroir dichroïque 230.

En sortie du miroir dichroïque 230, les chemins optiques du signal lumineux 211 et du signal lumineux 221 sont confondus.

Le miroir dichroïque 230 forme des moyens de déviation de faisceau, agencés pour superposer les chemins optiques suivis par les signaux lumineux 211 et 221.

Ici, on obtient cette superposition à l'aide du miroir dichroïque seul, grâce à l'agencement des deux matrices de LED orthogonales entre elles.

L'invention n'est cependant pas limitée à cet exemple, d'autres agencements des matrices de LED pouvant être mis en œuvre, les moyens de déviation de faisceau pouvant alors comprendre des éléments optiques supplémentaires.

Le système 200 selon l'invention comprend ici en outre un système optique de projection 240, comprenant au moins une optique réfractive, et configuré pour former, en un plan de focalisation déterminé, une image agrandie alternativement de la première et de la seconde matrice de LED (selon que ce soit le premier ou le second dispositif matriciel d'affichage émissif qui émette un signal lumineux).

En fonctionnement, le système 200 selon l'invention émet, pour chacune parmi une pluralité d'images en couleurs :
- un signal lumineux 211A, correspondant à la composante verte de l'image en couleurs (voir figure 4A) ;
- un signal lumineux 211B, correspondant à la composante bleue de l'image en couleurs (voir figure 4B) ; et
- un signal lumineux 221, correspondant à la composante rouge de l'image en couleurs (voir figure 4C).

Les différentes composantes chromatiques d'une même image en couleurs peuvent être émises tour à tour, ce qui correspond à une projection de type purement séquentiel. Ces différentes composantes chromatiques peuvent alors se succéder dans un ordre ou dans un autre.

En variante, les composantes verte et bleu d'une même image en couleurs sont émises tour à tour (dans un ordre ou dans un autre), tandis que la composante rouge est émise durant l'émission de la composante bleue et/ou verte. On peut parler de projection partiellement séquentielle. L'émission de la composante rouge peut avoir lieu pendant toute ou partie de la durée d'émission de la composante bleue et/ou verte.

La succession desdites composantes chromatiques peut être pilotée par des moyens de commande, non représentés, configurés pour piloter l'affichage successif des composantes chromatiques d'une pluralité d'images en couleurs.

Les différentes composantes chromatiques se succèdent en particulier selon une fréquence *f* de N composantes par seconde, correspondant à un défilement d'images en couleurs à une fréquence de 3*N images par seconde dans le cas purement séquentiel, ou 2*N images par seconde dans le cas partiellement séquentiel.

La valeur de N est généralement égale à 50. Il peut être avantageux pour la qualité d'image (notamment diminuer le papillotement) d'augmenter cette valeur de N, à 100 ou 200. L'invention permet d'avoir accès à de telles valeurs de N, grâce à l'utilisation de matrices de LED présentant un temps de réponse très rapide. De telles valeurs ne sont pas atteignables avec des systèmes selon l'art antérieur basés sur l'utilisation de micro-écrans tels que des micro-écrans LCD.

Les moyens de commande mentionnés ci-dessus ne seront pas décrits ici plus en détail. En effet, leurs détails de mise en œuvre ne présentent pas de difficulté pour l'homme du métier, spécialiste de l'affichage en couleurs de type séquentiel.

Dans la seconde matrice de LED, l'intensité lumineuse émise par chaque LED est fonction de l'amplitude de sa tension d'alimentation.

Les moyens de commande sont donc configurés pour convertir des niveaux de gris sur la composante rouge d'une image en couleurs, en valeurs d'amplitude de tensions d'alimentation respectives, en entrée de chaque LED de ladite seconde matrice.

Il est équivalent de considérer que lesdits moyens de commande sont configurés pour convertir des niveaux de gris en valeurs de courant d'alimentation de LED, la tension et le courant étant liés.

Dans la première matrice de LED, l'amplitude de la tension d'alimentation d'une LED permet de sélectionner une émission dans le bleu ou dans le vert.

Les différentes valeurs d'intensité lumineuse nécessaires à l'obtention d'images en niveaux de gris sont alors obtenues par modulation de largeur d'impulsion, l'œil n'étant sensible qu'à une valeur moyenne d'intensité lumineuse du signal lumineux modulé émis par chaque LED.

L'intensité lumineuse émise par une LED est donc fonction du rapport entre une largeur des impulsions de tension et leur période de répétition, l'amplitude des impulsions étant fixée. Dans la suite, ce rapport est nommé simplement « rapport cyclique ».

Dans tout le texte, le terme « amplitude » désigne une valeur maximale du signal, et non une valeur moyenne, ou une valeur efficace d'amplitude. La valeur de l'amplitude telle que définie ici n'est donc pas fonction du rapport entre la largeur des impulsions de tension et leur période de répétition.

Les moyens de commande sont donc configurés pour convertir des niveaux de gris sur la composante verte, respectivement bleue, en valeurs respectives de rapports cycliques de tensions d'alimentation respectives, en entrée de chaque LED de ladite première matrice.

Là-encore, il est équivalent de considérer que c'est l'amplitude du courant d'alimentation d'une LED qui permet de sélectionner une émission dans le bleu ou dans le vert, et que lesdits moyens de commande sont configurés pour convertir des niveaux de gris en valeurs de rapport cyclique de courant d'alimentation de LED, la tension et le courant étant liés.

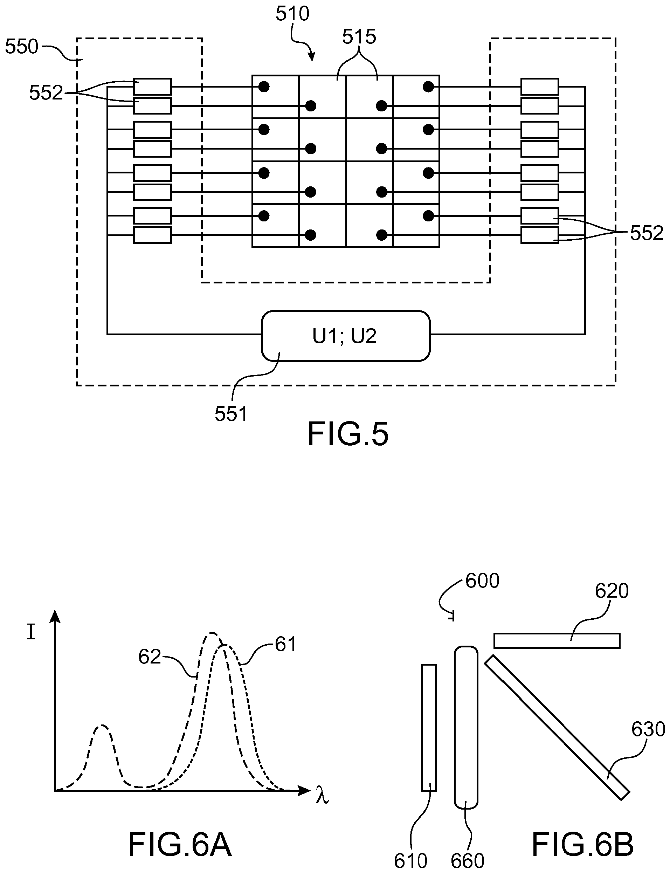

La figure 5 représente de manière schématique le premier dispositif d'affichage matriciel 510, et des moyens de pilotage 550 de celui-ci, dits premiers moyens de pilotage.

Ces premiers moyens de pilotage 550 appartiennent aux moyens de commande mentionnés ci-dessus.

Ils comprennent :
- des moyens 551 de sélection d'une amplitude des tensions d'alimentation, parmi une première valeur U1 associée à l'affichage de la composante verte d'une image en couleurs, et une deuxième valeur U2 associée à l'affichage de la composante bleue de la même image ; et
- des unités 552 de modulation de largeur d'impulsion, associées chacune à l'une des LED 515 de la matrice de LED du premier dispositif d'affichage matriciel 510, et configurées chacune pour réaliser une modulation de largeur d'impulsion, selon un rapport cyclique prédéterminé.

Il y a donc autant d'unités 552 que de LED dans la première matrice de LED.

De préférence, chaque unité 552 convertit un signal continu à la valeur U1 (respectivement U2) en un signal alternatif, de préférence rectangulaire, alternant entre la valeur U1 et une valeur inférieure à U1, de préférence la valeur zéro (respectivement entre la valeur U2 et une valeur inférieure à U2, de préférence la valeur zéro).

On mentionne ici uniquement des éléments de pilotage des LED, pertinents au regard de l'invention, une matrice active de LED comportant, de façon connue, de nombreuses autres connexions pour l'adressage des LED.

Les figures 6A et 6B illustrent un deuxième mode de réalisation d'un système 600 de projection d'images selon l'invention.

Le système 600 ne sera décrit que pour ses différences relativement au premier mode de réalisation de l'invention.

Le système 600 est illustré en figure 6B. Afin d'alléger la figure, on n'a pas représenté de lentille de projection en sortie du miroir dichroïque 630, une telle lentille n'étant pas essentielle à la définition de l'invention.

Ici, les LED de la première matrice de LED ne comportent qu'un seul type de puits quantiques, adaptés à une émission dans le vert. Tous les puits quantiques sont associés à un même spectre d'émission (à tensions d'alimentation égales, voir plus loin).

Plus particulièrement, chacune de ces LED comporte des empilements de couches alternativement en GaN et en InGaN formant des puits quantiques pour des porteurs de charges. La concentration en indium dans les couches en InGaN présente une valeur adaptée à une émission dans le vert.

Comme précédemment, chacune de ces LED est adaptée à émettre tour à tour la composante bleue et la composante verte d'une image en couleurs.

On exploite pour cela, de manière astucieuse, un effet connu de décalage vers le bleu (« *blueshift* », en anglais) lorsque l'amplitude de la tension d'alimentation augmente fortement.

Ce décalage a été identifié, notamment dans l'article « Electrical, spectral and optical performance of yellow-green and amber micro-pixelated InGaN light-emitting diodes », Z. Gong & al., Semiconductor Science and Technology, 27 (2012) 015003 (7 pp).

Cet article s'intéresse cependant à la suppression de ce décalage spectral, tandis que l'invention propose au contraire de l'exploiter pour obtenir au choix une émission dans le vert ou une émission dans le bleu.

La figure 6A illustre les spectres d'émission d'une LED du premier dispositif d'affichage matriciel 610, pour une première tension d'alimentation (spectre 61) et pour une deuxième tension d'alimentation d'amplitude bien supérieure (spectre 62).

Lorsque la LED est alimentée par la première tension d'alimentation, son spectre 61 présente un pic d'émission dans le vert.

Le cas échéant, ce spectre peut présenter des pics supplémentaires, non exploités par le système de projection d'images, situés en dehors du spectre visible et du proche ultra-violet.

En tout état de cause, on considère dans la suite que le spectre 61 est monochromatique, et correspond à une émission monochromatique dans le vert.

Lorsque la LED est alimentée par la deuxième tension d'alimentation, son spectre 62 présente un pic d'émission dans le bleu.

On remarque qu'ici, le spectre 62 présente également un pic d'émission dans le vert.

Ce pic d'émission, marginal, peut être supprimé par simple optimisation des LED du premier dispositif d'affichage matriciel 610.

Ici, on utilise un filtre spectral, décrit dans la suite, pour obtenir l'émission d'un signal monochromatique dans le bleu.

Comme précédemment, la première tension d'alimentation (associée à l'émission dans le vert) est strictement inférieure à la deuxième tension d'alimentation (associée à l'émission dans le bleu).

Afin d'obtenir cet effet de décalage spectral, la différence entre ces deux tensions doit être élevée, par exemple supérieure à 2 V.

Ici, la première tension d'alimentation vaut 4 V, et la deuxième tension d'alimentation vaut 6,5 V.

Tous les détails relatifs au pilotage des LED s'appliquent également dans ce deuxième mode de réalisation de l'invention.

Le système 600 selon l'invention comporte ici un filtre spectral 660, configuré pour :
- laisser passer des longueurs d'onde comprises entre 440 nm et 500 nm (bleu), et bloquer des longueurs d'onde comprises entre 510 nm et 570 nm (vert), lorsque le premier dispositif d'affichage matriciel 610 émet dans le bleu et le vert (valeur haute de la tension d'alimentation) ; et
- laisser passer des longueurs d'onde comprises entre 510 nm et 570 nm (vert), lorsque le premier dispositif d'affichage matriciel 610 émet dans le vert et n'émet pas dans le bleu (valeur basse de la tension d'alimentation).

Le filtre 660 est donc avantageusement un filtre accordable en longueur d'onde dont les caractéristiques de filtrage dépendent d'un signal électrique de commande. Un filtre accordable en longueur d'onde donne accès à des vitesses de commutation très élevées, compatibles avec une fréquence de succession des composantes chromatiques, pour une projection vidéo en couleurs.

Le filtre 660 est positionné sur le chemin optique du signal lumineux émis par le premier dispositif d'affichage matriciel 610, de préférence entre ce dispositif 610 et le miroir dichroïque 630.

Le pilotage du filtre 660 accordable en longueur d'onde et le pilotage des LED sont synchronisés ensemble par des moyens de synchronisation, non représentés.

Ainsi, à l'aide du filtre 660, le premier dispositif d'affichage matriciel 610 permet d'obtenir tour à tour un signal monochromatique dans le bleu, correspondant à la composante chromatique bleue d'une image en couleurs, et un signal monochromatique dans le vert, correspondant à la composante chromatique verte d'une image en couleurs.

L'invention n'est cependant pas limitée à cette solution pour réaliser le filtre. En variante, le filtre spectral 660 comprend une roue à filtre comportant deux régions. Une première région comporte un filtre spectral qui laisse passer le bleu et bloque le vert. Une seconde région est transparente, sans filtre spectral. Là-encore, la rotation de la roue à filtre est synchronisée avec le pilotage des LED du premier dispositif d'affichage matriciel 610.

Le deuxième mode de réalisation de l'invention offre une fabrication plus aisée que le premier mode de réalisation (un seul type de puits quantiques dans la première matrice de pixels), mais un rendement électro-optique plus réduit (besoin d'une tension d'alimentation plus élevée pour obtenir une émission dans le bleu).

L'invention n'est pas limitée aux exemples décrits ci-dessus, et de nombreuses variantes peuvent être mises en œuvre sans sortir du cadre de l'invention.

Par exemple, les dispositifs matriciels d'affichage émissif peuvent être constitués chacun d'autres types de diodes électroluminescentes que les exemples cités.

Le cas échéant, un filtre tel que décrit ci-dessus peut être combiné avec le premier mode de réalisation de l'invention, lorsque l'excitation d'un type de puits quantiques entraîne l'excitation de l'autre type de puits quantiques, dans la première matrice de LED.

De manière similaire, on peut mettre en œuvre une variante sans filtre du deuxième mode de réalisation de l'invention, lorsque le décalage en fréquence vers le bleu s'accompagne d'une réduction notable de l'amplitude du pic d'émission dans le vert.

L'invention peut également utiliser une autre décomposition spectrale que la décomposition en couleurs primaires rouge, bleu et vert.

L'invention trouve des applications avantageuses dans le domaine des projecteurs compacts, et des afficheurs tête haute (ou HUD pour l'anglais « *Head up display* »).

## Revendications

1. Système (200 ; 600) de projection d'images, configuré pour mettre en œuvre une projection en couleurs, **caractérisé en ce qu'**il comprend :
- un premier dispositif matriciel d'affichage émissif (210 ; 510 ; 610), configuré pour l'émission d'une première et d'une deuxième composantes chromatiques (211A, 211B) d'une image en couleurs, et comprenant une première matrice de pixels dans laquelle chaque pixel est constitué d'une diode électroluminescente adaptée à émettre aux longueurs d'onde associées à ladite première composante chromatique (211A) et aux longueurs d'onde associées à ladite deuxième composante chromatique (211B) ; et
- un second dispositif matriciel d'affichage émissif (220 ; 620), configuré pour l'émission d'une troisième composante chromatique (221) de l'image en couleurs.

2. Système (200 ; 600) de projection d'images selon la revendication 1, **caractérisé en ce que** :
- ladite première matrice de pixels est constituée d'une première matrice de diodes électroluminescentes, dans laquelle chaque diode électroluminescente (515) présente un spectre d'émission qui dépend de l'amplitude de sa tension d'alimentation ; et
- le premier dispositif matriciel d'affichage émissif (510) est connecté à des premiers moyens de pilotage (550), configurés pour fournir auxdites diodes électroluminescentes (515) des tensions d'alimentation respectives présentant alternativement une première amplitude (U1), associée à l'émission de la première composante chromatique, et une seconde amplitude (U2), associée à l'émission de la deuxième composante chromatique.

3. Système (200 ; 600) de projection d'images selon la revendication 2, **caractérisé en ce que** les premiers moyens de pilotage (550) comprennent des unités (552) de modulation de largeur d'impulsion, chaque diode électroluminescente (515) de ladite première matrice étant associée à une unité (552) de modulation de largeur d'impulsion respective.

4. Système (200) de projection d'images selon l'une quelconque des revendications 1 à 3, **caractérisé en ce que** les diodes électroluminescentes de ladite première matrice sont des diodes à multi-puits quantiques, comprenant chacune deux types de puits quantiques, qui diffèrent par un spectre d'émission respectif (31, 32) associé.

5. Système (600) de projection d'images selon l'une quelconque des revendications 1 à 3, **caractérisé en ce que** les diodes électroluminescentes de ladite première matrice sont des diodes à multi-puits quantiques, et comprennent chacune des puits quantiques d'un seul type, tous associés à un même spectre d'émission (61; 62).

6. Système (200 ; 600) de projection d'images selon l'une quelconque des revendications 1 à 5, **caractérisé en ce que** les diodes électroluminescentes de ladite première matrice sont des diodes à base de nitrure de gallium-indium (InGaN).

7. Système (200 ; 600) de projection d'images selon l'une quelconque des revendications 1 à 6, **caractérisé en ce que** le second dispositif matriciel d'affichage émissif (220 ; 620) comprend une seconde matrice de diodes électroluminescentes, à base de phosphure d'aluminium-gallium-indium (InGaAIP).

8. Système (200 ; 600) de projection d'images selon l'une quelconque des revendications 1 à 7, **caractérisé en ce que** :
- le premier dispositif matriciel d'affichage émissif (210 ; 510 ; 610) est configuré pour l'émission d'une composante verte et d'une composante bleue d'une image en couleurs ; et
- le second dispositif matriciel d'affichage émissif (220 ; 620) est configuré pour l'émission d'une composante rouge de ladite image en couleurs.

9. Système (200 ; 600) de projection d'images selon l'une quelconque des revendications 1 à 8, **caractérisé en ce qu'**il présente en outre des moyens (230 ; 630) de déviation de faisceau, agencés pour superposer les chemins optiques suivis par les signaux lumineux (211, 221) émis respectivement par le premier et par le second dispositifs matriciels d'affichage émissif.

10. Système (200 ; 600) de projection d'images selon la revendication 9, **caractérisé en ce que** les moyens (230 ; 630) de déviation de faisceau consistent en un miroir dichroïque.

11. Système (200 ; 600) de projection d'images selon l'une quelconque des revendications 1 à 10, **caractérisé en ce que** le premier dispositif matriciel d'affichage émissif (210 ; 510 ; 610) comprend ladite première matrice de pixels, le second dispositif matriciel d'affichage émissif (220 ; 620) comprend une seconde matrice de pixels, et chacune des première et seconde matrices de pixels est une matrice carrée ou rectangulaire de côté(s) compris entre 5 mm et 20 mm.

## Patentansprüche

1. Bildprojektionssystem (200; 600), das dazu ausgelegt ist, eine Farbprojektion auszuführen, **dadurch gekennzeichnet, dass** es enthält:
- eine erste emittierende Anzeigematrixvorrichtung (210; 510; 610), die dazu ausgelegt ist, eine erste und eine zweite Farbkomponente (211A, 211B) eines Farbbildes zu emittieren, und die eine erste Pixelmatrix enthält, in der jedes Pixel aus einer Leuchtdiode besteht, die dazu ausgebildet ist, bei Wellenlängen, die der ersten Farbkomponente (211A) zugeordnet sind, und bei Wellenlängen, die der zweiten Farbkomponente (211B) zugeordnet sind, zu emittieren; und
- eine zweite emittierende Anzeigematrixvorrichtung (220; 620), die dazu ausgelegt ist, eine dritte Farbkomponente (221) des Farbbildes zu emittieren.

2. Bildprojektionssystem (200; 600) nach Anspruch 1, **dadurch gekennzeichnet, dass**:
- die erste Pixelmatrix aus einer ersten Leuchtdiodenmatrix besteht, bei der jede Leuchtdiode (515) ein Emissionsspektrum aufweist, das von der Amplitude ihrer Versorgungsspannung abhängt; und
- die erste emittierende Anzeigematrixvorrichtung (510) mit ersten Ansteuerungsmitteln (550) verbunden ist, die dazu ausgelegt sind, an die Leuchtdioden (515) entsprechende Versorgungsspannungen zu liefern, die abwechselnd eine erste Amplitude (U1), die der Emission der ersten Farbkomponente zugeordnet ist, und eine zweite Amplitude (U2), die der Emission der zweiten Farbkomponente zugeordnet ist, aufweisen.

3. Bildprojektionssystem (200; 600) nach Anspruch 2, **dadurch gekennzeichnet, dass** die ersten Ansteuerungsmittel (550) Pulsweitenmodulationseinheiten (552) enthalten, wobei jede Leuchtdiode (515) der ersten Matrix einer jeweiligen Pulsweitenmodulationseinheit (552) zugeordnet ist.

4. Bildprojektionssystem (200) nach einem der Ansprüche 1 bis 3, **dadurch gekennzeichnet, dass** die Leuchtdioden der ersten Matrix Multi-Quantentopf-Dioden sind, die jeweils zwei Typen von Quantentöpfen umfassen, die sich durch ein jeweils zugehöriges Emissionsspektrum (31, 32) unterscheiden.

5. Bildprojektionssystem (600) nach einem der Ansprüche 1 bis 3, **dadurch gekennzeichnet, dass** die Leuchtdioden der ersten Matrix Multi-Quantentopf-Dioden sind und jeweils Quantentöpfe eines einzigen Typs umfassen, die alle einem gleichen Emissionsspektrum (61; 62) zugeordnet sind.

6. Bildprojektionssystem (200; 600) nach einem der Ansprüche 1 bis 5, **dadurch gekennzeichnet, dass** die Leuchtdioden der ersten Matrix Dioden auf Basis von Gallium-Indium-Nitrid (InGaN) sind.

7. Bildprojektionssystem (200; 600) nach einem der Ansprüche 1 bis 6, **dadurch gekennzeichnet, dass** die zweite emittierende Anzeigematrixvorrichtung (220; 620) eine zweite Matrix von Leuchtdioden auf Basis von Aluminium-Gallium-Indium-Phosphid (InGaAIP) enthält.

8. Bildprojektionssystem (200; 600) nach einem der Ansprüche 1 bis 7, **dadurch gekennzeichnet, dass**:
- die erste emittierende Anzeigematrixvorrichtung (210; 510; 610) dazu auslegt ist, eine grüne Komponente und eine blaue Komponente eines Farbbildes zu emittieren; und
- die zweite emittierende Anzeigematrixvorrichtung (220; 620) dazu ausgelegt ist, eine rote Komponente des Farbbildes zu emittieren.

9. Bildprojektionssystem (200; 600) nach einem der Ansprüche 1 bis 8, **dadurch gekennzeichnet, dass** es ferner Strahlablenkungsmittel (230; 630) aufweist, die so angeordnet sind, dass sie die optischen Pfade überlagern, denen die Lichtsignale (211, 221) folgen, die von der ersten bzw. der zweiten emittierenden Anzeigematrixvorrichtung emittiert werden.

10. Bildprojektionssystem (200; 600) nach Anspruch 9, **dadurch gekennzeichnet, dass** die Strahlablenkungsmittel (230; 630) aus einem dichroitischen Spiegel bestehen.

11. Bildprojektionssystem (200; 600) nach einem der Ansprüche 1 bis 10, **dadurch gekennzeichnet, dass** die erste emittierende Anzeigematrixvorrichtung (210; 510; 610) die erste Pixelmatrix enthält, die zweite emittierende Anzeigematrixvorrichtung (220; 620) eine zweite Pixelmatrix enthält, und jede aus erster und zweiter Pixelmatrix eine quadratische oder rechteckige Matrix mit einer Seite bzw. Seiten zwischen 5 mm und 20 mm ist.

## Claims

1. Image projection system (200; 600), configured to implement a colour projection, **characterised in that** it comprises:
- a first emissive matrix display device (210; 510; 610), configured to emit first and second chromatic components (211A, 211B) of a colour image, and comprising a first pixel matrix in which each pixel is composed of a light emitting diode adapted to emit at wavelengths associated with said first chromatic component (211A) and at wavelengths associated with said second chromatic component(211B); and
- a second emissive matrix display device (220; 620), configured to emit a third chromatic component (221) of the colour image.

2. Image projection system (200; 600) according to claim 1, **characterised in that**:
- said first pixel matrix is composed of a first matrix of light emitting diodes, wherein each light emitting diode (515) has an emission spectrum that depends on the amplitude of its power supply voltage; and
- the first emissive matrix display device (510) is connected to first control means (550) configured to supply said light emitting diodes (515) with power supply voltages that alternately have a first amplitude (U1) associated with emission of the first chromatic component, and a second amplitude (U2) associated with emission of the second chromatic component.

3. Image projection system (200; 600) according to claim 2, **characterised in that** the first control means (550) comprise pulse width modulation units (552), each light emitting diode (515) in said first matrix being associated with a corresponding pulse width modulation unit (552).

4. Image projection system (200) according to any one of claims 1 to 3, **characterised in that** the light emitting diodes of said first matrix are multi-quantum well diodes, each comprising two types of quantum wells, which have different corresponding associated emission spectra (31, 32).

5. Image projection system (600) according to any one of claims 1 to 3, **characterised in that** the light emitting diodes of said first matrix are multi-quantum well diodes, each comprising a single type of quantum wells, all of which are associated with the same emission spectrum (61, 62).

6. Image projection system (200, 600) according to any one of claims 1 to 5, **characterised in that** the light emitting diodes of said first matrix are diodes based on indium gallium nitride (InGaN).

7. Image projection system (200, 600) according to any one of claims 1 to 6, **characterised in that** the second emissive matrix display device (220; 620) comprises a second matrix of light emitting diodes, based on indium gallium aluminium phosphide (InGaAIP).

8. Image projection system (200; 600) according to any one of claims 1 to 7, **characterised in that**:
- the first emissive matrix display device (210; 510; 610) is configured to emit a green component and a blue component of a colour image; and
- the second emissive matrix display device (220; 620) is configured to emit a red component of said colour image.

9. Image projection system (200; 600) according to any one of claims 1 to 8, **characterised in that** it also comprises beam deviation means (230; 630) arranged to superpose the optical paths followed by light signals (211, 221) emitted by the first and the second emissive matrix display devices respectively.

10. Image projection system (200; 600) according to claim 9, **characterised in that** the beam deviation means (230; 630) consist of a dichroic mirror.

11. Image projection system (200; 600) according to any one of claims 1 to 10, **characterised in that** the first emissive matrix display device (210; 510; 610) comprises said first pixel matrix, the second emissive matrix display device (220; 620) comprises a second pixel matrix, and each of the first and second pixel matrices is a square or rectangular matrix with side dimensions equal to between 5 mm and 20 mm.
